# EUROPÄISCHE PATENTANMELDUNG

(11) **EP 2 023 706 A2**
(43) Veröffentlichungstag der Anmeldung: **11.02.2009**
(21) Anmeldenummer: 08104842.3
(22) Anmeldetag: 23.07.2008
(51) Int. Cl.: H05K 7/20

(54) **Schaltungsträgeraufbau mit verbesserter Wärmeableitung**

(30) Priorität: 07.08.2007 DE 102007037297
(71) Anmelder: Continental Automotive GmbH, 30165 Hannover (DE)
(72) Erfinder: Decker, Michael, 93055 Regensburg (DE)

(57) **Zusammenfassung**

Die Erfindung betrifft einen Schaltungsträgeraufbau (1) mit mindestens einen elektronischen Bauelement (3) in SMD-Bauweise, wobei unterhalb des mindestens einen elektronischen Bauelements (3) eine durchgehende Ausnehmung (5) im Schaltungsträger (2) angeordnet ist, ein Stempel (6) aus wärmeleitendem Material mit einem Ende eines Fügebereichs (6a) in die Ausnehmung (5) eingeführt und mit einer Wärmeleitkleberschicht (7) befestigt wird und mit dem Bauelement (3) wärmeleitend verbunden wird und weiterhin der Stempel (6) an seiner anderen Seite einen Anbindungsbereich (6b) aufweist, dessen Querschnittsfläche mindestens teilweise größer dimensioniert ist als die Ausnehmung (5) im Schaltungsträger (2) und dessen Ende mit einem Kühlkörper (8) wärmeleitend verbunden wird.

## Beschreibung

Die Erfindung betrifft einen Schaltungsträgeraufbau gemäß dem Oberbegriff des Patentanspruchs 1 sowie ein Verfahren zur Herstellung eines solchen Schaltungsträgeraufbaus, insbesondere für Anwendungen in der Kraftfahrzeugindustrie.

### Stand der Technik

In der Entwicklung der Leiterplattentechnik spielen die ständig steigenden Anforderungen der elektrischen Verbindungstechnik eine große Rolle. Die Bestückungsdichte elektrischer Bauelemente auf Leiterplatten nimmt immer mehr zu, da immer komplexere Schaltungen auf immer kleinerem Raum unterzubringen sind. Durch eine hohe Bestückungsdichte und durch den Einsatz von Leistungsbauelementen, die teilweise eine hohe Verlustleistung in Form von Wärme erzeugen, werden auch zunehmende Anforderungen an ein besseres Wärmemanagement, das heißt die gezielte Abführung der Verlustwärme vom Entstehungsort und deren Abgabe an die Umgebung, gestellt.

Es sind verschiedene Konzepte bekannt, um bei Schaltungsträgeraufbauten eine Ableitung der durch die Leistungseinheiten erzeugten Wärme zu erreichen.

Ein Ansatz besteht darin, die von elektronischen Bauelementen erzeugte Verlustleistung in die Leiterplatte einzukoppeln, die durch ihren Kupferlagenanteil die Wärme verteilen und abführen kann. Die Leiterplatte kann dabei auf eine metallische Trägerplatte aufgebracht sein, die als Kühlkörper der Wärmeabfuhr dient. Gleichermaßen können gerade die Leistungsbauelemente in SMD-Bauweise zusätzlich aus einem Grundkörper und einem lötfähigen Unterteil, das neben der mechanischen Stabilisierung auch als Kühlfläche dient, der so genannten Wärmefahne bestehen.

Die SMD-Bauelemente sind üblicherweise bei Schaltungsträgeraufbauten auf der dem Kühlkörper abgewandten Oberseite der Leiterplatte aufgebracht. Um die Wärmeableitung vom SMD Bauelement durch den Schaltungsträger vertikal zum Kupferlagenaufbau zum Kühlkörper deutlich zu verbessern ist es bekannt, die Leiterplatte unterhalb der aufliegenden Leistungsbauelemente mit galvanisierten Durchkontaktierungen, so genannten Thermo Vias zu versehen. Derartige Durchkontaktierungen bestehen herkömmlich aus die Leiterplatte durchdringenden Bohrungen geringen Durchmessers (≤1 mm). Diese können mit Wärmeleitmaterialien, wie Pasten, Gelen oder Kleber gefüllt sein. Selbst bei einer Vielzahl von Durchkontaktierungen unterhalb eines einzelnen Leistungsbauelements ergibt sich jedoch aufgrund der Geometrie der Durchkontaktierung oftmals nur eine ungenügende Wärmeabfuhr vom Bauelement zum Kühlkörper.

In der DE 43 26 506 A1 ist eine mit SMD-Leistungsbauelementen bestückte Leiterfolie offenbart, die zur mechanischen Stabilisierung und zur Verbesserung der Wärmeableitung der von den Leistungsbauelementen erzeugten Wärme auf eine Trägerplatte aufgebracht ist. Unterhalb des Leistungsbauelementes ist auf der Leiterfolie eine lötfähige Randschicht ausgebildet, die eine großflächige Ausnehmung begrenzt. Diese Ausnehmung ist mit einer wärmeleitenden Masse, bevorzugt mit einer Lötpaste, aufgefüllt, so dass ein großflächiger Wärmetransport vom Leistungsbauelement zur Trägerplatte möglich ist.

Mit der Einführung der Kupfer-Inlay-Technologie konnte die Wärmeabführung gegenüber dem Einsatz von Thermo-Vias deutlich verbessert werden. Durch das Einfügen von massiven Kupferelementen, den so genannten Kupfer-Inlays, in eine Leiterplatte kann die durch die Verlustleistung entstehende Wärme von elektrischen Bauelementen besonders gut abgeführt werden. Der thermische Widerstand der Leiterplatte kann auf diese Weise deutlich reduziert werden. Kritische Temperaturanstiege können vermieden und die Baugruppe innerhalb der zulässigen Temperaturgrenzen betrieben und gehalten werden. Hierdurch können die Zuverlässigkeit und die Lebensdauer von elektronischen Baugruppen deutlich gesteigert werden. Solche Baugruppen sind auch für den Einsatz in der Hochfrequenztechnik geeignet. Ein Kupfer-Inlay kann in voller Leiterplattendicke in die Leiterplatte eingepresst werden und in seiner Dimensionierung an die Leiterplattendicke angepasst sein. Das Kupfer-Inlay dient dabei einerseits mit seiner gesamten Oberseitenfläche als Lötfläche für die Aufbringung von elektrischen Bauelementen und andererseits als Hochleistungswärmeleitpfad durch die Leiterplatte. Das Kupfer-Inlay kann dann an seiner Unterseite wiederum je nach Anforderung mit dem Gehäuse oder einem zusätzlichen Kühlkörper mit bekannten Wärmeleitklebern oder Wärmeleitfolien verbunden werden. Die Anbindung des Inlays an elektrische Bauelemente mittels Weichlot hat den Nachteil, dass diese mechanisch instabil ist und leicht brüchig werden kann. Bruchstellen bedeuten wiederum, dass die Wärmeleitfähigkeit deutlich abnimmt. Zudem kann diese Art der Anbindung keinen Spannungsschutz bieten und eine Wärmeabführung von elektrischen potentialgeführten Bauelementen kann auf diese Weise nicht erfolgen.

Ein weiteres bekanntes Konzept zur Wärmeabführung von elektrischen Bauelementen ist das so genannte Top cooling. Bei Bauteilen mit gebogenen Anschlussbeinchen(Gullwings)besteht die Möglichkeit eine Wärmefahne vom Schaltungsträger wegweisend aufzubauen. Hierbei wird die thermische Anbindung nicht durch den Schaltungsträger realisiert, sondern direkt auf einem Kühlkörper. Bauelemente, die auf diese Weise auf die Schaltungsträgerabgewandte Seite an einen Kühlkörper angebunden werden, haben je nach Bauelementetyp und Hersteller unterschiedliche Größen und Höhen. Soll ein möglichst geringer thermischer Widerstand realisiert werden, können Kühlkörper und Bauelementeplatzierung beim Top cooling Konzept nur in Abhängigkeit zueinander und nicht unabhängig voneinander entwickelt werden.

Eine sichere und effektive Wärmeabführung von elektronischen Leistungsbauelementen hat direkten Einfluss auf deren Lebensdauer und damit auf die Zuverlässigkeit von Schaltungsträgern und der gesamten damit gebildeten Elektronikeinrichtungen. Die Entwicklung neuer alternativer Konzepte für Hochleistungswärmeleitpfade spielt daher für die Entwicklung neuer Elektronikbausteine und -geräte eine große Rolle.

### Aufgabenstellung

Aufgabe der Erfindung ist es daher, einen Schaltungsträger umfassend mindestens ein elektronisches Bauelement, insbesondere in SMD-Bauweise, bereit zu stellen, welcher eine verbesserte und sichere Ableitung der durch elektronische Bauelemente erzeugten Wärme ermöglicht und somit die Lebensdauer der Bauelemente verlängern kann.

Dies wird erfindungsgemäß mit einer Vorrichtung entsprechend des Patentanspruchs 1 sowie mit einem Verfahren zur Herstellung einer solchen Vorrichtung gemäß Anspruch 13 erreicht.

Erfindungsgemäß wird ein Schaltungsträgeraufbau mit mindestens einem elektronischem Bauelement in SMD-Bauweise vorgeschlagen, bei dem unterhalb des mindestens einen SMD-Bauelements eine durchgehende Ausnehmung im Schaltungsträger angeordnet ist, ein Stempel aus wärmeleitendem Material mit einem Ende eines Fügebereichs in die Ausnehmung eingeführt und mit einem Wärmeleitkleber befestigt und mit dem Bauelement wärmeleitend verbunden wird und weiterhin der Stempel an seiner anderen Seite einen Anbindungsbereich aufweist, dessen Querschnittsfläche mindestens teilweise größer dimensioniert ist als die Ausnehmung im Schaltungsträger und dessen Ende mit einem Kühlkörper wärmeleitend verbunden wird.

Erfindungsgemäß wird damit ein Schaltungsträgeraufbau bereitgestellt, mit dem ein zuverlässiger und verbesserter Wärmetransport vom SMD-Bauelement zum Kühlkörper ermöglicht wird. Vorteilhafterweise kann dabei eine zeitlich unabhängige Entwicklung von Kühlkörper und Bauelementeplatzierung auf dem Schaltungsträger erfolgen und gleichzeitig ein möglichst geringer thermischer Widerstand realisiert werden. Dies kann erheblich den Entwicklungsaufwand für einen Schaltungsträgeraufbau reduzieren.

Als Schaltungsträger kann erfindungsgemäß bevorzugt eine PCB-Leiterplatte (Printed Circuit Board) eingesetzt werden. Die elektronischen Bauelemente können auf jede bekannte Weise, bevorzugt mittels Reflow-Lötverfahren auf dem Schaltungsträger befestigt sein. Die Ausnehmung kann beispielsweise in den Schaltungsträger gebohrt oder gefräst sein und kann in ihren Randabmessungen jeweils kleiner dimensioniert sein als die entsprechende Abmessung des SMD-Bauelements, so dass weiterhin eine sichere Befestigung des SMD-Bauelements auf dem Schaltungsträger gewährleistet ist. Die Ausnehmung kann metallisiert, vorzugsweise mit einer abgeschiedenen Kupferschicht versehen sein.

Der Stempel weist erfindungsgemäß einen Fügebereich und einen Anbindungsbereich auf. Unter Fügebereich wird erfindungsgemäß der Teil des Stempels verstanden, der dem Schaltungsträger zugewandt ist und dessen Ende in die Ausnehmung im Schaltungsträger eingeführt wird. Der Fügebereich des Stempels und die Ausnehmung können vorteilhafterweise als Passung ausgeführt sein. Das heißt der Fügebereich kann in seiner Umfangsform an die Ausnehmung angepasst sein, so dass sich ein vorteilhafter Presssitz ergibt. Hierdurch kann die Einkopplung der Wärme in den Schaltungsträger im Verbindungsbereich und auch die mechanische Befestigung des Stempels verbessert werden. Der Fügebereich kann die volle Schaltungsträgerdicke einnehmen oder darüber hinausragen. Unter Anbindungsbereich wird erfindungsgemäß der Teil des Stempels verstanden, der dem Kühlkörper zugewandt ist und dessen Endbereich mit dem Kühlkörper wärmeleitend verbunden wird. Der Anbindungsbereich des Stempels weist mindestens teilweise eine größere Querschnittsfläche auf als die Ausnehmung im Schaltungsträger. Durch die somit vergrößerte Oberfläche kann die Wärme seitlich besser an die Umgebung und an seinem Ende besser an den Kühlkörper ableiten. Der Stempel mit Fügebereich und Anbindungsbereich ist bevorzugt einstückig ausgeführt, da hierdurch innerhalb des Stempels der geringste thermische Widerstand gewährleistet ist. Er kann aber auch aus mehreren Teilen zusammengesetzt sein, die wiederum wärmeleitend miteinander verbunden sind.

Der Stempel kann in einer bevorzugten Ausgestaltung durch den vergrößerten Querschnitt des Anbindungsbereichs zum Fügebereich eine Stufe aufweisen. Gleichermaßen bevorzugt kann sich der Stempel in seinem Querschnitt vom Fügebereich zum Anbindungsbereich hin kontinuierlich aufweiten, so dass sich beispielsweise eine im Wesentlichen konische Form ergibt. Alternativ kann sich der Stempel im Anbindungsbereich zu seinem Endbereich hin im Querschnitt wieder verjüngen.

In einer anderen bevorzugten Ausführungsform kann der Anbindungsbereich des Stempels zur Verbindung mit dem Kühlkörper zusätzlich ein Gewinde aufweisen. Hierdurch kann die mechanische Stabilität der Verbindung zum Kühlkörper deutlich verbessert werden.

Der Wärmeleitkleber kann auf jeder bekannten Klebstoffgrundmatrix, beispielsweise auf Silikon, Epoxid, Polyurethan oder Polyimid basieren. Durch die enthaltenen Anteile metallischer oder keramischer Füllstoffe in der Grundmatrix können Wärmeleitkleber vorteilhafterweise eine gute Wärmeleitung vom SMD-Bauelement zum Stempel sicherstellen. Zudem kann erfindungsgemäß so viel Wärmeleitkleber verwendet werden, dass in der Ausnehmung eine geschlossene Verbindung zwischen Schaltungsträger Stempel hergestellt wird. Somit kann zum einen die mechanische Befestigung, darüber hinaus aber auch die Einkopplung der Wärme in die Leiterplatte in diesem Verbindungsbereich verbessert werden.

Der Stempel kann bevorzugter Weise aus einem metallischen oder keramischen Material bestehen. Besonders bevorzugt ist er aus Aluminium, das Wärme besonders gut ableiten kann.

In einer weiteren bevorzugten Ausgestaltung kann der Stempel aus einem lötbaren Material, bevorzugt aus CuNi, Nickel <Alloy 42>, Sn oder Ag bestehen. Gleichermaßen bevorzugt kann der Stempel mit einer lötbaren Beschichtung, bevorzugt aus AuNi, Sn, Ag, Pt oder Pd versehen sein.

Um eine verbesserte und definiertere Wärmeableitung zu erzielen kann der Stempel in einer bevorzugten Weiterbildung über ein thermisches Interface Material an den Kühlkörper angebunden sein, beispielsweise verschraubt, verpresst, verschweißt oder geklebt werden. Unter thermischem Interface Material wird jedes Material verstanden, mit dem vorteilhafterweise die thermischen Kontaktwiderstände durch Oberflächenrauhigkeiten zwischen Stempel und dem Kühlkörper reduziert werden können. Je nach Anforderung kann das thermische Interface Material ein elektrisch isolierendes oder ein elektrisch leitfähiges Material sein. Beispiele für thermische Interface Materialien sind Wärmeleitmaterialien, wie Kleber, Pasten, Gele oder Klebefolien, wie Polyimidfolien oder keramisch gefüllte Silikonfolien.

In einer weiteren bevorzugten Ausgestaltung kann der Stempel mindestens teilweise mit Längskerbungen versehen sein. Auf diese Weise kann die Oberfläche des Stempels vergrößert und die direkte Wärmeableitung an die jeweilige Umgebung verbessert werden. Besonders bevorzugt kann der Stempel im Fügebereich Längskerbungen aufweisen und zusätzlich vorteilhafterweise Relativbewegungen zwischen dem Schaltungsträger und dem Stempel unterbinden und zur mechanischen Befestigung des Stempels am Schaltungsträger beitragen.

In einer anderen bevorzugten Ausgestaltung kann der Stempel mit einer elektrisch isolierenden Beschichtung versehen sein. Diese Beschichtung kann als elektrischer Spannungsschutz dienen. Auf diese Weise können vorteilhafterweise auch elektrisch potentialgeführte Bauelemente mit dem thermisch leitenden Stempel an den Kühlkörper angeschlossen und gleichzeitig ein zuverlässiger Wärmetransport ermöglicht werden. Die elektrisch isolierende Beschichtung kann beispielsweise eine Lackschicht, eine Emailschicht, eine Eloxierschicht oder eine elektrisch isolierende Folienschicht, beispielsweise aus Polyimid oder Teflon sein. In einer besonders bevorzugten Ausführungsform besteht der Stempel aus eloxiertem Aluminium. Die Beschichtung kann vorteilhafterweise eine Dicke im Bereich ≤ 25 µm aufweisen, so dass eine gute Ableitung der Wärme gewährleistet bleibt.

Zur Herstellung eines erfindungsgemäßen Schaltungsträgeraufbaus mit mindestens einem elektronischen Bauelement in SMD Bauweise wird unterhalb des Bauelements eine durchgehende Ausnehmung in den Schaltungsträger eingebracht. Die Ausnehmung kann beispielsweise durch Fräsen oder Bohren hergestellt und anschließend gegebenenfalls metallisiert werden. Das SMD-Bauelement kann auf bekannte Weise, beispielsweise mittels Weichlot am Schaltungsträger befestigt sein. In die Ausnehmung kann eine geringe Menge Wärmeleitkleber eingeführt werden, die vorteilhafterweise durch die enthaltenen Anteile metallischer oder keramischer Füllstoffe eine gute Wärmeleitung gewährleisten können. In die Ausnehmung wird anschließend das Ende des Fügebereichs eines Stempels aus wärmeleitendem Material eingeführt und mit dem Wärmeleitkleber am SMD Bauelement und am Schaltungsträger befestigt. Die Menge des Wärmeleitkleber-Materials ist dabei abhängig von der Kontaktfläche zum Stempel, des verwendeten Füllstoffs sowie dessen Schichtstärke. Die Schichtstärke kann idealerweise an der Partikelverteilung gängiger Füllstoffe gewählt werden. Die Untergrenze der Schichtstärke orientiert sich dabei an den größten Füllstoffpartikeln. Gängige Materialien weisen Partikelgrößen von 40 µm auf. Die Masse des Füllstoffs bestimmt sich dabei nach der Formel M = V·ϕ, wobei ϕ die spezifische Dichte des Füllstoffmaterials ist, die typischerweise zwischen 2 bis 4 g/cm³ liegt und V das Volumen V = A·d_{Schicht} (A = Fläche · d = Dicke) des Füllspaltes darstellt. Anschließend kann der Stempel mit dem Ende seines Anbindungsbereichs mit einem Kühlkörper verbunden werden. Die Verbindung kann beispielsweise durch verschrauben, verpressen, verschweißen oder Kleben hergestellt werden.

Auf diese Weise können Schaltungsträgeraufbauten mit thermisch belastenden SMD-Bauteilen mit hoher Langzeitstabilität zur Verfügung gestellt werden.

Die Erfindung wird nachfolgend in beispielhafter Weise anhand von einer Ausführungsvariante in Verbindung mit der Zeichnung erläutert, ohne hierauf beschränkt zu sein.

In dieser zeigt:

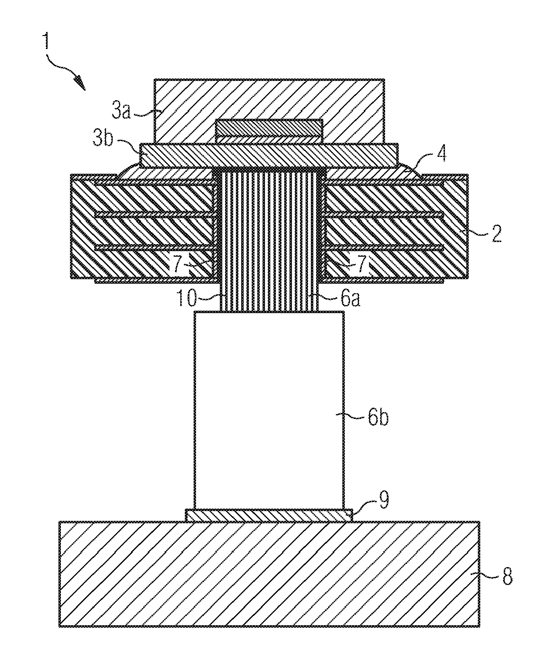

**Fig. 1** eine Schnittdarstellung eines erfindungsgemäßen Schaltungsträgeraufbaus.

**Fig. 1** zeigt eine Schnittdarstellung eines Schaltungsträgeraufbaus **1,** mit einem auf einem Schaltungsträger **2** befestigten SMD Bauelement **3.** Das SMD-Bauelement **3** wird durch einen Grundkörper **3a** und einer Wärmefahne als Unterteil **3b** gebildet, das vorteilhafterweise zur mechanischen Unterstützung und zur Wärmeableitung beiträgt. Das SMD-Bauteil **3** ist bevorzugt mittels Weichlot **4** am Schaltungsträger **2** befestigt. Der Schaltungsträger **2** ist besonders bevorzugt eine PCB Leiterplatte(Printed Circuit Board). Unterhalb des SMD-Bauteils **3** ist eine Ausnehmung **5** in den Schaltungsträger eingebracht, die beispielsweise gebohrt oder gefräst sein kann. Die Ausnehmung **5** kann metallisiert, vorzugsweise mit einer abgeschiedenen Kupferschicht versehen sein. In die Ausnehmung **5** wird ein Ende eines Stempels **6** aus wärmeleitendem metallischem oder keramischem Material eingeführt und mit einer Wärmeleitkleberschicht **7** an der Wärmefahne **3b** befestigt. Der Stempel **6** wird aus einem Fügebereich **6a** und einem Anbindungsbereich **6b** gebildet. Das Ende des Fügebereichs **6a** ist das Ende des Stempels, das in die Ausnehmung des Schaltungsträgers eingeführt wird, während der Anbindungsbereich **6b** mit seinem Ende mit einem Kühlkörper **8** verbunden wird. Der Anbindungsbereich weist mindestens teilweise eine größere Querschnittsfläche auf, als die Ausnehmung im Schaltungsträger **2.** Das Ende des Anbindungsbereichs **6b** kann vorzugsweise über eine Schicht aus thermischem Interface Material **9** mit dem Kühlkörper **8** verbunden, beispielsweise verschraubt, verpresst, verschweißt oder geklebt werden. Vorteilhafterweise können hierdurch die thermischen Kontaktwiderstände durch Oberflächenrauhigkeiten zwischen Stempel **5** und dem Kühlkörper **8** reduziert werden. Der Stempel **6** kann mindestens teilweise, bevorzugt im Fügebereich **6a,** mit Längskerbungen **10** versehen sein. Auf diese Weise kann zum einen die Oberfläche des Stempels **6** vergrößert und die direkte Wärmeableitung an die Umgebung verbessert werden. Zum anderen können zusätzlich vorteilhafterweise Relativbewegungen zwischen dem Schaltungsträger **2** und dem Stempel **6** unterbunden werden.

Zusammenfassend wird demnach ein Schaltungsträgerkonzept vorgeschlagen, bei dem bei dem die Wärmeableitung und Anbindung eines SMD-Bauelements an einen Kühlkörper verbessert und zuverlässig und langzeitstabil sichergestellt werden kann. Der bereitgestellte Schaltungsträger ist dabei leicht und variabel konfektionierbar und kann mit Standardprozessen gefertigt werden. Vorteilhafterweise können mit dem erfindungsgemäßen Konzept ein möglichst geringer thermischer Widerstand realisiert werden und dennoch Kühlkörper und die Bauelementeplatzierung auf dem Schaltungsträger unabhängig voneinander entwickelt werden. Die Montage ist daher leicht und kostengünstig in den Gesamtmontageprozess einer elektronischen Vorrichtung integrierbar.

## Patentansprüche

1. Schaltungsträgeraufbau (1) mit mindestens einen elektronischen Bauelement(3)in SMD-Bauweise, **dadurch gekennzeichnet, dass** unterhalb des mindestens einen elektronischen Bauelements (3) eine durchgehende Ausnehmung (5)im Schaltungsträger (2)angeordnet ist, ein Stempel (6) aus wärmeleitendem Material mit einem Ende eines Fügebereichs (6a) in die Ausnehmung (5) eingeführt und mit einer Wärmeleitkleberschicht (7) befestigt wird und mit dem Bauelement (3) wärmeleitend verbunden wird und weiterhin der Stempel (6) an seiner anderen Seite einen Anbindungsbereich (6b) aufweist, dessen Querschnittsfläche mindestens teilweise größer dimensioniert ist als die Ausnehmung (5) im Schaltungsträger (2) und dessen Ende mit einem Kühlkörper (8) wärmeleitend verbunden wird.

2. Schaltungsträgeraufbau (1) nach Anspruch 1, **dadurch gekennzeichnet, dass** der Stempel (6) aus metallischem oder keramischem Material besteht.

3. Schaltungsträgeraufbau (1) nach Anspruch 1 oder 2, **dadurch gekennzeichnet, dass** der Stempel (6) eine im Wesentlichen konische Form aufweist.

4. Schaltungsträgeraufbau (1) nach Anspruch 1 oder 2, **dadurch gekennzeichnet, dass** der Anbindungsbereich (6b) des Stempels (6) sich zu seinem Endbereich hin im Querschnitt verjüngt.

5. Schaltungsträgeraufbau (1) nach einem der vorhergehenden Anspruche 1 bis 4, **dadurch gekennzeichnet, dass** der Anbindungsbereich (6b) des Stempels (6) zur Verbindung mit dem Kühlkörper (8) zusätzlich ein Gewinde aufweist.

6. Schaltungsträgeraufbau (1) nach einem der vorhergehenden Ansprüche 1 bis 5, **dadurch gekennzeichnet, dass** der Stempel (6) aus einem lötbaren Material, bevorzugt aus CuNi, Nickel <Alloy 42>, Sn oder Ag besteht.

7. Schaltungsträgeraufbau (1) nach einem der vorhergehenden Ansprüche 1 bis 6, **dadurch gekennzeichnet, dass** der Stempel (6) mit einer lötbaren Beschichtung versehen ist.

8. Schaltungsträgeraufbau (1) nach einem der vorhergehenden Ansprüche 1 bis 6, **dadurch gekennzeichnet, dass** der Stempel (6) mit einer elektrisch isolierenden Beschichtung versehen ist.

9. Schaltungsträgeraufbau (1) nach Anspruch 8, **dadurch gekennzeichnet, dass** die Beschichtung eine Eloxalschicht, eine Lackschicht, eine Emailschicht oder eine elektrisch isolierende Folienschicht ist.

10. Schaltungsträgeraufbau (1) nach einem der vorhergehenden Ansprüche 1 bis 9, **dadurch gekennzeichnet, dass** der Stempel (6), bevorzugt im Fügebereich (6a), mindestens teilweise mit Längskerbungen (10) versehen ist.

11. Schaltungsträgeraufbau (1) nach einem der vorhergehenden Ansprüche 1 bis 10, **dadurch gekennzeichnet, dass** zwischen dem Anbindungsbereich (6b) des Stempels (6) und dem Kühlkörper (8) ein thermisches Interface Material (9) angeordnet ist.

12. Schaltungsträgeraufbau(1) nach Anspruch 11, **dadurch gekennzeichnet, dass** das thermische Interface Material (9) ein elektrisch isolierendes oder ein elektrisch leitfähiges Material ist.

13. Verfahren zur Herstellung eines Schaltungsträgeraufbaus (1) mit mindestens einem elektronischen Bauelement (3) in SMD-Bauweise mit den Merkmalen mindestens eines der vorhergehenden Ansprüche, **dadurch gekennzeichnet, dass** unterhalb des Bauelements (3) eine durchgehende Ausnehmung (5) in den Schaltungsträger (2) eingebracht und gegebenenfalls metallisiert wird, nachfolgend eine Wärmeleitkleberschicht (7)in die Ausnehmung (5) eingebracht und ein Ende eines Fügebereichs (6a) eines Stempels (6) aus wärmeleitendem metallischem oder keramischen Material eingeführt und mit dem Wärmeleitkleber befestigt wird und weiterhin der Stempel (6) mit dem Ende seines Anbindungsbereichs (6b) mit einem Kühlkörper (8) wärmeleitend verbunden wird.

14. Verwendung eines Schaltungsträgeraufbaus (1) nach einem der vorhergehenden Ansprüche 1 bis 12 bevorzugt für Anwendungen in der Kraftfahrzeugindustrie.
